# FASCICULE DE BREVET EUROPEEN

(11) **EP 2 101 380 B1**
(45) Date de publication et mention de la délivrance du brevet: **15.05.2019**
(21) Numéro de dépôt: 09154593.9
(22) Date de dépôt: 09.03.2009
(51) Int. Cl.: H01S 5/10, H01S 5/02, H01S 5/042

(54) **Système à microdisque à modes de galerie pour sources optiques pompées électriquement**
Mikroplattensystem mit Galerie-Modi für elektrisch gepumpte optische Quellen
Microdisc system with gallery modes for electrically pumped optical sources

(30) Priorité: 12.03.2008 FR 0851604
(43) Date de publication de la demande: 16.09.2009
(73) Titulaire: Commissariat à l'Énergie Atomique et aux Énergies Alternatives, 75015 Paris (FR); Centre National de la Recherche Scientifique, 75016 Paris (FR); Ecole Centrale de Lyon, 69134 Ecully Cedex (FR)
(72) Inventeur: Mandorlo, Fabien, 63730 Les Martres de Veyre (FR); Fedeli, Jean-Marc, 38120 Saint Egrève (FR); Rojo-Romeo, Pedro, 69006 Lyon (FR)
(74) Mandataire: Ilgart, Jean-Christophe

(56) Documents cités:
- EP-A- 0 533 390
- EP-A- 0 995 969
- WO-A-2005/053000
- US-A- 4 431 308
- US-A- 5 317 587
- THIYAGARAJAN S M K ET AL: "Continuous room-temperature operation of microdisk laser diodes" ELECTRONICS LETTERS, IEE STEVENAGE, GB, vol. 35, no. 15, 22 juillet 1999 (1999-07-22), pages 1252-1254, XP006012430 ISSN: 0013-5194
- VAN CAMPENHOUT J ET AL: "Design and Optimization of Electrically Injected InP-Based Microdisk Lasers Integrated on and Coupled to a SOI Waveguide Circuit" JOURNAL OF LIGHTWAVE TECHNOLOGY, IEEE SERVICE CENTER, NEW YORK, NY, US, vol. 26, no. 1, 1 janvier 2008 (2008-01-01), pages 52-63, XP011202725 ISSN: 0733-8724
- ROMEO P R ET AL: "InP on Silicon Electrically Driven Microdisk Lasers for Photonic ICs", INDIUM PHOSPHIDE AND RELATED MATERIALS CONFERENCE PROCEEDINGS, 2006 IN TERNATIONAL CONFERENCE ON PRINCETON, NJ MAY 7, 2006, PISCATAWAY, NJ, USA,IEEE, 7 May 2006 (2006-05-07), pages 60-63, XP010917553, DOI: 10.1109/ICIPRM.2006.1634111 ISBN: 978-0-7803-9558-9

## Description

### DOMAINE TECHNIQUE

L'invention se rapporte à des systèmes à microdisque à modes de galerie pour sources optiques pompées électriquement. Elle concerne en particulier l'intégration de l'optique dans les systèmes électroniques pour la génération de signaux optiques.

### ETAT DE LA TECHNIQUE ANTERIEURE

On connaît des micro-lasers dont le résonateur est constitué d'un microdisque ou d'un microanneau. Un résonateur à microdisque ou à microanneau, exploitant des modes de galerie (appelés « whispering gallery modes » dans les articles en langue anglaise) permet d'obtenir un fort confinement des photons. Il en est de même pour un microrésonateur constitué par une microstructure à base de cristal photonique à une ou deux dimensions.

Les disques à modes de galerie (MG) se caractérisent par des modes électromagnétiques respectant la géométrie de révolution du disque : on distingue donc les modes par leur ordre radial (nombre de noeuds sur un rayon), leur ordre azimutal (le nombre de périodes) et leur ordre vertical (nombre de noeuds dans l'épaisseur du disque). Ces disques sont réalisés dans un matériau de fort indice comportant un milieu à gain, et baignent dans un milieu de plus faible indice (air, silice...), peu ou pas absorbant à la longueur d'onde d'intérêt.

Les modes de plus fort facteur de qualité correspondant à des ordres radiaux et verticaux nuls, les modes généralement utilisés pour réaliser un laser à MG se situent donc en périphérie de disque. L'utilisation de membranes fines (épaisseur en dessous de la longueur d'onde), limitant les ordres verticaux, pour réaliser le disque aboutit à des modes peu confinés, couramment dits « en mode TE » (ou « quasi-TE ») ou « mode TM » (ou « quasi TM ») selon la direction dominante du champ magnétique, perpendiculaire au plan du disque ou dans son plan. Pour ces membranes fines, le champ évanescent selon la direction verticale est important : il peut d'ailleurs être utilisé pour réaliser le couplage vers un guide. Si le pompage optique de tels dispositifs est facilement réalisable, il n'en est pas de même pour le pompage électrique. La présence de contacts électriques sur les faces principales du microdisque peut entraîner des pertes conséquentes dues à leur absorption dans l'infrarouge (ou la longueur d'onde de travail). Il est donc important de contrôler la manière d'assurer les contacts électriques avec le disque.

Le contact inférieur du microdisque (c'est-à-dire le contact situé sur la face du microdisque la plus proche du substrat support) peut être réalisé de différentes façons. Le contact inférieur peut se présenter avec un piédestal (voir le document « Continuous wave lasing in GaInAsP microdisk injection laser with threshold current of 40 µA » de M. Fujita et al., Electronics Letters, 27 avril 2000, Vol. 36, No.9) ou en laissant une couche conductrice de fort indice pour déporter le contact à côté du disque (voir le document « Heterogeneous integration of electrically driven microdisk based laser sources for optical interconnects and photonic ICs » de P. Rojo Romeo et al., Optics Express, Vol. 14, No.9, pages 3864 à 3871, 1er mai 2006). Cette dernière solution est difficile à appliquer au contact supérieur et l'épaisseur laissée pour le contact limite en partie le facteur de qualité.

L'utilisation de matière pour entourer le disque et permettre une utilisation au sein d'une puce électronique entraîne un contraste d'indice moins élevé qu'avec un disque entouré d'air : il est alors nécessaire d'augmenter la taille des dispositifs pour atteindre des facteurs de qualité suffisants et réduire le seuil du mode laser (typiquement de l'ordre de 2000 au moins).

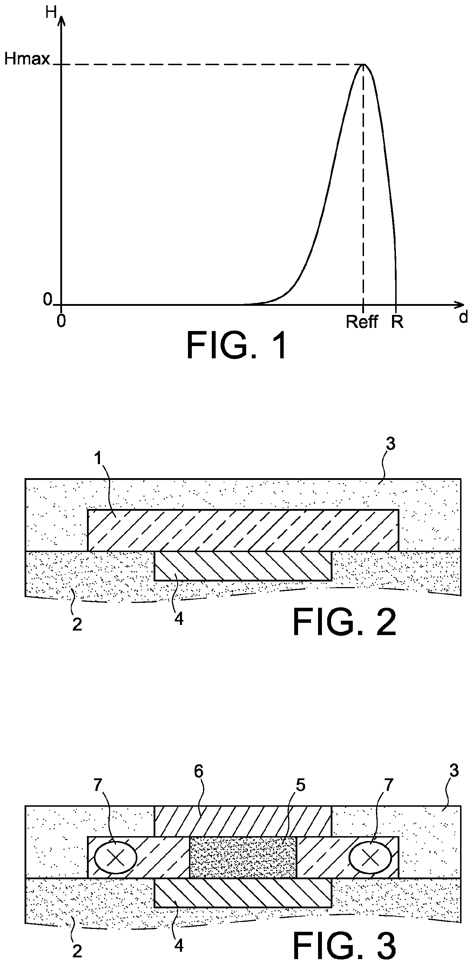

Pour garantir un facteur de qualité élevé, au moins un des contacts, généralement le contact supérieur, le plus souvent métallique ou plus généralement absorbant, est situé au centre du disque, d'un rayon nécessairement inférieur à Reff, qui correspond au maximum du champ dans le disque. La figure 1 est un graphe représentant l'allure de la distribution du champ magnétique H dans un microdisque de rayon R en fonction de la distance d par rapport au centre du disque. La valeur maximale du champ magnétique Hmax est obtenue pour une valeur de d égale à Reff, Reff étant inférieure au rayon R du disque.

Le milieu à gain se trouvant dans le disque, on pourra remarquer :
- que seules les recombinaisons électron-trou en bord de disque participent aux modes de fort facteur de qualité,
- que la diffusion limite les performances des dispositifs et qu'il est nécessaire de contacter au plus près possible du bord du disque,
- qu'actuellement, au moins un des contacts occupe systématiquement tout le centre de la structure.
Il est également connu du document EP 0995969 A, de l'article de Van Campenhout J. et al. publié le 1er janvier 2008 dans la revue scientifique « Journal of Lightware Technology » volume 23 numéro 1 pages 52 à 63, et de l'article de Rojo Romeo P. et al. publié le 1er mai 2006 dans la revue scientifique « Optics Express » volume 14 numéro 9 pages 3864 à 3871, des systèmes à microdisque.

### EXPOSÉ DE L'INVENTION

L'invention a pour but de limiter les recombinaisons de porteurs peu utiles au centre du disque, en modifiant les propriétés électriques de ce dernier, et la géométrie voire la nature du contact. La présente invention permet ainsi d'injecter efficacement des porteurs pour obtenir un pompage plus efficace et un seuil laser plus faible.

L'invention a pour objet un système à microdisque conforme à la revendication 1. Des modes particuliers de réalisation de l' invention sont définis dans les revendications dépendantes.

La couche de protection a un double rôle. Elle permet de garantir un contraste d'indice suffisant avec l'indice du microdisque afin de confiner le mode optique. Elle permet aussi d'encapsuler l'ensemble de la structure afin d'obtenir un système mécaniquement rigide.

De préférence, le substrat est un support utilisé en micro-électroniqe recouvert d'une couche de matériau électriquement isolant et à faible indice de réfraction.

Selon une première variante de réalisation, la partie centrale du microdisque électriquement neutralisée est une partie implantée d'ions, par exemple d'ions H⁺.

Selon une deuxième variante de réalisation, la partie centrale du microdisque est un noyau en matériau électriquement isolant d'une épaisseur inférieure ou égale à celle du microdisque. De préférence, le noyau est en matériau d'indice optique plus faible que celui du matériau constituant le microdisque, par exemple en SiO₂, Si₃N₄ ou en SiOₓN_{y}. Le contact supérieur est connecté électriquement à un conducteur électrique du substrat par une liaison électrique passant au travers du noyau. De préférence, la liaison électrique est en un matériau peu ou pas absorbant à la longueur d'onde à laquelle le système à microdisque est destiné à fonctionner. Le contact inférieur peut alors être un anneau dans lequel passe la liaison électrique.

Selon un mode de réalisation particulier, la partie inférieure du microdisque est de plus grand diamètre que le reste du microdisque pour constituer une partie annulaire sur laquelle est localisé le contact inférieur.

L'invention a aussi pour objet une source optique pompée électriquement, comprenant un système à microdisque tel que défini ci-dessus.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1, déjà décrite, est un graphe représentant l'allure de la distribution du champ magnétique dans un microdisque à modes de galerie en fonction de la distance par rapport au centre du disque ;
- la figure 2 est une vue en coupe transversale d'un microdisque sur son substrat support au cours de sa réalisation, selon l'invention ;
- la figure 3 est une vue en coupe transversale d'un microdisque sur son substrat support en fin de réalisation;
- la figure 4 est une vue en coupe transversale d'un autre microdisque sur son substrat support en fin de réalisation;
- la figure 5 est une vue en coupe transversale d'encore un autre microdisque sur son substrat support en fin de réalisation, selon l'invention,
- la figure 6 est une vue en coupe transversale d'encore un autre microdisque sur son substrat support en fin de réalisation, selon l'invention.

### EXPOSÉ DÉTAILLÉ DE MODES DE RÉALISATION PARTICULIERS

La figure 2 est une vue en coupe transversale d'un microdisque sur son substrat support au cours de sa réalisation, selon l'invention.

Sur la figure 2, la référence 1 représente un microdisque, par exemple en InP. Le microdisque 1 est obtenu par une technique connue de l'homme du métier. Il est formé sur un substrat 2 en silicium (ou sur tout autre support utilisé en micro-électronique) recouvert d'une couche d'oxyde de silicium (ou d'un autre matériau électriquement isolant à faible indice de réfraction). Les faces inférieure et supérieure du microdisque 1 comprennent des zones dopées pour permettre l'obtention d'un contact électrique avec des électrodes ou contacts reliant électriquement les faces du microdisque avec une source de courant.

Le microdisque est recouvert d'une couche de protection 3 en matériau de faible indice optique et électriquement isolant. C'est par exemple une couche de silice (SiO₂) ou de nitrure (Si₃N₄) ou d'un composé SiOₓN_{y} déposée par dépôt sous vide (PVD, PECVD,...) et d'épaisseur supérieur ou égale à celle de la membrane 1.

Le substrat 2 comporte un contact inférieur 4, par exemple en ITO permettant de contacter les zones dopées du microdisque grâce à un collage métallique.

Des étapes de procédés microélectroniques peuvent être prévues après ceci. Il peut s'agir d'étapes de dépôt, de gravure, etc...

Les lignes de courant ont peu d'intérêt dans le centre du microdisque. Selon l'invention, celles passant habituellement dans le centre du microdisque sont neutralisées. La référence 5 représente une partie centrale du microdisque 1 neutralisée électriquement (voir la figure 3).

Cette neutralisation des lignes de courant peut se faire selon divers procédés dont deux vont être décrits.

Un premier procédé consiste à neutraliser la partie centrale de la zone dopée du microdisque qui réalise l'un des contacts électriques. Par exemple, une implantation d'ions H⁺ permet de neutraliser électriquement une région en InP dopée p⁺.

Un deuxième procédé consiste à remplacer le coeur du disque par un noyau en matériau électriquement isolant. La zone neutralisée sera de préférence plus éloignée des bords du disque pour laisser de la place pour le contact. Ce matériau électriquement isolant peut présenter un faible indice optique. Il peut s'agir du même matériau que celui de la couche de protection 3, par exemple de la silice. Dans ce cas, il convient de noter que la structure obtenue est différente d'un anneau. En effet, pour un anneau, le mode est centré dans la structure de fort indice, ce qui n'est pas le cas ici, puisque le champ sous le contact doit être faible. De plus, ce disque évidé présente un certain nombre de modes radiaux identiques (en position spectrale) à ceux du disque standard. Enfin, cela revient à ne modifier le disque que dans les zones où le champ du mode qu'on recherche à exciter est très négligeable, ce qui permet aussi de négliger l'influence de la rugosité sur cette paroi intérieure.

Sur la figure 3, la référence 6 représente le contact supérieur. Ce contact est formé par gravure de la couche de protection 3 jusqu'à atteindre le microdisque, pour définir l'emplacement du contact supérieur. Avant la formation du contact supérieur, la partie centrale du microdisque est neutralisée électriquement, soit par implantation d'ions H⁺, soit par gravure et remplissage de la partie centrale par un matériau électriquement isolant.

La référence 7 sur la figure 3 représente un mode de galerie.

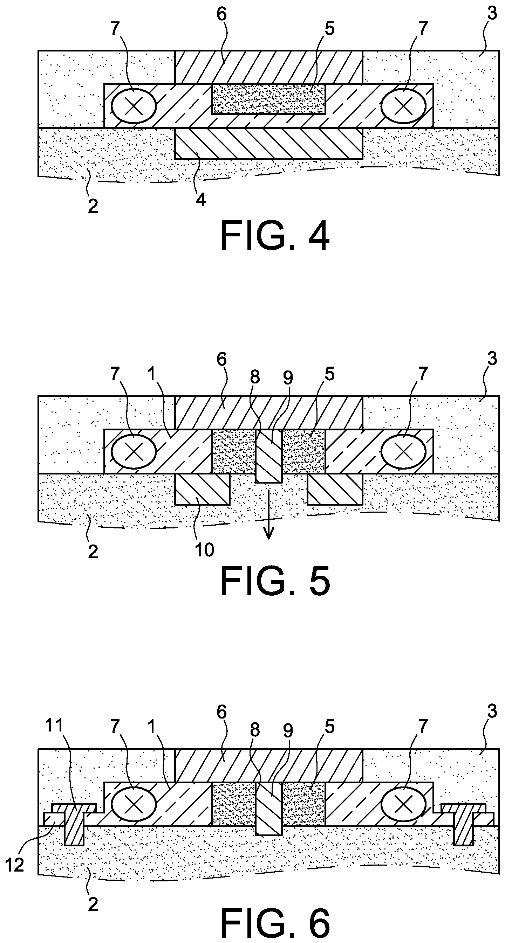

Sur la figure 3, toute l'épaisseur de la partie centrale (ou noyau) du microdisque était neutralisée. Selon la variante de réalisation montrée à la figure 4, l'épaisseur du noyau 5 est inférieure à l'épaisseur du microdisque.

Dans le cas de l'utilisation d'un isolant électrique pour neutraliser la partie centrale du microdisque, le noyau isolant peut être percé selon l'axe du microdisque pour le passage d'une liaison électrique vers une couche métallique de connexion située dans le substrat.

La figure 5 illustre une telle solution. Le noyau 5 en matériau électriquement isolant est percé d'un trou central 8 obtenu par exemple par gravure. Le trou 8 est rempli d'un matériau électriquement conducteur réalisant une liaison électrique 9 vers le substrat 2 comme l'indique la flèche sur la figure. Dans ce cas, le contact électrique inférieur, référencé 10 sur la figure 5, peut être un anneau.

La proximité de la liaison électrique 9 avec le mode électromagnétique, présent dans le microdisque en fonctionnement, peut introduire des pertes. Pour cette raison, il est préférable que le matériau électriquement conducteur constituant la liaison électrique 9 soit choisi parmi les matériaux à la fois électriquement conducteurs et peu (voire pas) absorbant à la longueur d'onde de fonctionnement. En place et lieu de composés métalliques, on pourra faire appel à l'ITO (oxyde mixte d'étain et d'indium) pour remplir ce rôle en s'appuyant sur des simulations FDTD (pour « Finite Differences Time Domain » ou Différences Finies dans le domaine temporel).

La figure 6 est une vue en coupe transversale d'encore un autre microdisque sur son substrat support en fin de réalisation selon l'invention.

Sur cette figure, les mêmes références que sur la figure 5 représentent les mêmes éléments. La différence par rapport à la figure 5 réside dans la localisation du contact électrique inférieur. On remarque que la partie inférieure du microdisque est de plus grand diamètre que le reste du microdisque pour constituer une partie annulaire 12. Le contact électrique inférieur 11 est localisé sur la partie annulaire 12. Les lignes de courant dans le microdisque seront donc parallèles au plan du microdisque.

Le contact électrique inférieur illustré sur la figure 6 peut aussi être utilisé dans le mode de réalisation illustré par les figures 3 ou 4.

## Revendications

1. Système à microdisque à modes de galerie pour source optique pompée électriquement, le microdisque (1) étant formé sur une face d'un substrat (2) et étant parallèle au substrat, la partie du microdisque reposant sur le substrat étant dite partie inférieure et comprenant une face dite inférieure, la partie du microdisque opposée à la partie inférieure du microdisque étant dite partie supérieure et comprenant une face dite supérieure, ladite face supérieure comprenant une zone dopée, la zone dopée de la face supérieure permettant l'obtention d'un contact électrique avec une électrode dite contact supérieur (6), la partie centrale (5) du microdisque étant électriquement neutralisée pour empêcher le passage d'un courant électrique dans ladite partie centrale, ladite face inférieure comprenant une zone dopée, la zone dopée de la face inférieure permettant un contact électrique avec une électrode dite contact inférieur (4), ladite partie supérieure du microdisque étant recouverte d'une couche de protection (3) en matériau électriquement isolant et d'indice optique inférieur à l'indice optique du matériau constituant le microdisque, **caractérisé en ce que** la partie centrale (5) du microdisque (1) est
- soit un noyau en matériau électriquement isolant,
- soit partiellement constituée par un noyau (5) en matériau électriquement isolant, et
**en ce que** le contact supérieur (6) est connecté électriquement à un conducteur électrique du substrat par une liaison électrique (9) passant au travers du noyau (5).

2. Système à microdisque selon la revendication 1, dans lequel le l'électrode de contact inférieur est réalisée dans un oxyde d'indium-étain (ITO).

3. Système à microdisque selon la revendication 1 ou 2, dans lequel le substrat est un support utilisé en micro-électroniqe recouvert d'une couche de matériau électriquement isolant et à faible indice de réfraction.

4. Système à microdisque selon la revendication 3, dans lequel le substrat (2) est en silicium recouvert d'une couche d'oxyde de silicium.

5. Système à microdisque selon l'une quelconque des revendications 1 à 4, dans lequel le microdisque (1) est en InP.

6. Système à microdisque selon l'une quelconque des revendications 1 à 5, dans lequel la couche de protection (3) est en SiO₂, Si₃N₄, SiOₓN_{y}.

7. Système à microdisque selon l'une quelconque des revendications précédentes, dans lequel le noyau (5) est en matériau d'indice optique plus faible que celui du matériau constituant le microdisque.

8. Système à microdisque selon la revendication 7, dans lequel le noyau (5) est en SiO₂, en Si₃N₄ ou en SiOₓN_{y}.

9. Système à microdisque selon l'une quelconque des revendications précédentes, dans lequel ladite liaison électrique (9) est en un matériau peu ou pas absorbant à la longueur d'onde à laquelle le système à microdisque est destiné à fonctionner.

10. Système à microdisque selon la revendication 9, dans lequel ladite liaison électrique (9) est en oxyde mixte d'étain et d'indium (ITO).

11. Système à microdisque selon l'une quelconque des revendications précédentes, dans lequel le contact inférieur (10) est un anneau dans lequel passe ladite liaison électrique (9).

12. Système à microdisque selon l'une quelconque des revendications précédentes, dans lequel la partie inférieure du microdisque est de plus grand diamètre que le reste du microdisque pour constituer une partie annulaire (12) sur laquelle est localisé le contact inférieur (11).

13. Source optique pompée électriquement, comprenant un système à microdisque selon l'une quelconque des revendications 1 à 12.

## Patentansprüche

1. Mikrodisk-System mit Galeriemoden für eine elektrisch gepumpte optische Quelle, wobei die Mikrodisk (1) an einer Fläche eines Substrats (2) gebildet ist und parallel zu dem Substrat ist, wobei der auf dem Substrat ruhende Teil der Mikrodisk als unterer Teil bezeichnet ist und eine als untere bezeichnete Fläche umfasst, wobei der Teil der Mikrodisk gegenüber dem unteren Teil der Mikrodisk als oberer Teil bezeichnet ist und eine als obere bezeichnete Fläche umfasst, wobei die obere Fläche eine dotierte Zone umfasst, wobei die dotierte Zone der oberen Fläche das Erhalten eines elektrischen Kontakts mit einer Elektrode erlaubt, als oberer Kontakt (6) bezeichnet, wobei der zentrale Teil (5) der Mikrodisk elektrisch neutralisiert ist, um den Durchgang eines elektrischen Stroms in diesem zentralen Teil zu verhindern,
wobei die untere Fläche eine dotierte Zone umfasst, wobei die dotierte Zone der unteren Fläche einen elektrischen Kontakt mit einer Elektrode erlaubt, als unterer Kontakt (4) bezeichnet,
wobei der obere Teil der Mikrodisk mit einer Schutzschicht (3) aus einem Material bedeckt ist, welches elektrisch isolierend und von einem optischen Index ist, welcher kleiner ist als der optische Index des Materials, welches die Mikrodisk bildet,
**dadurch gekennzeichnet, dass** der zentrale Teil (5) der Mikrodisk (1):
- entweder ein Kern aus einem elektrisch isolierenden Material ist,
- oder teilweise durch einen Kern (5) aus einem elektrisch isolierenden Material gebildet ist, und
dass der obere Kontakt (6) mit einem elektrischen Leiter des Substrats durch eine elektrische Verbindung (9) elektrisch verbunden ist, welche durch den Kern (5) hindurch verläuft.

2. Mikrodisk-System nach Anspruch 1, wobei die Elektrode des unteren Kontakts aus einem Indium-Zinn-Oxid (ITO)gebildet ist.

3. Mikrodisk-System nach Anspruch 1 oder 2, wobei das Substrat ein Träger ist, welcher in einer Mikroelektronik verwendet wird, von einer Schicht aus einem elektrisch isolierenden Material mit einem schwachen Brechungsindex bedeckt.

4. Mikrodisk-System nach Anspruch 3, wobei das Substrat (2) aus Silizium ist, von einer Siliziumoxid-Schicht bedeckt.

5. Mikrodisk-System nach einem der Ansprüche 1 bis 4, wobei die Mikrodisk aus InP besteht.

6. Mikrodisk-System nach einem der Ansprüche 1 bis 5, wobei die Schutzschicht (3) aus SiO₂, Sl₃N₄, SiOₓN_{y} besteht.

7. Mikrodisk-System nach einem der vorhergehenden Ansprüche, wobei der Kern (5) aus einem Material mit einem schwächeren optischen Index als derjenige des Materials besteht, welches die Mikrodisk bildet.

8. Mikrodisk-System nach Anspruch 7, wobei der Kern (5) aus SiO₂, aus SI₃N₄ oder aus SiOₓN_{y} besteht.

9. Mikrodisk-System nach einem der vorhergehenden Ansprüche, wobei die elektrische Verbindung (9) aus einem Material besteht, welches die Wellenlänge wenig oder nicht absorbiert, bei welcher das Mikrodisk-System zu arbeiten vorgesehen ist.

10. Mikrodisk-System nach Anspruch 9, wobei die elektrische Verbindung (9) aus einem Mischoxid von Zinn und Indium (ITO)besteht.

11. Mikrodisk-System nach einem der vorhergehenden Ansprüche, wobei der untere Kontakt (10) ein Ring ist, in welchem die elektrischen Verbindung (9) hindurchtritt.

12. Mikrodisk-System nach einem der vorhergehenden Ansprüche, wobei der untere Teil der Mikrodisk von einem größeren Durchmesser ist als der Rest der Mikrodisk, um einen ringförmigen Teil (12) zu bilden, an welchem der untere Kontakt (11) platziert ist.

13. Elektrisch gepumpte optische Quelle, umfassend ein Mikrodisk-System nach einem der Ansprüche 1 bis 12.

## Claims

1. Gallery mode microdisc system for an electrically pumped optical source, the microdisc (1) being formed on one face of a substrate (2) and being parallel to the substrate, the part of the microdisc resting on the substrate being referred to as the lower part, the part of the microdisc opposite to the lower part of the microdisc being referred to as upper part and comprising a upper face, said upper part including a doped zone, the doped zone of the upper part allowing to provide an electrical contact with an electrode referred to as the upper contact (6), the central part (5) of the microdisc being electrically neutralised in order to prevent the passage of an electric current through said central part,
said lower face including a doped zone, the doped zone of the lower face allowing an electrical contact with an electrode referred to as the lower contact (4),
said upper part of the microdisc being covered with a protective layer (3) of electrically insulating material with an optical index lower than the optical index of the material constituting the microdisc,
**characterised in that** the central part(5) of the microdisc (1) is:
- whether a core made from electrically insulating material,
- whether partly made from electrically insulating material, and
**in that** the upper contact (6) is electrically connected to an electrical conductor of the substrate by an electrical connection (9) passing through the core (5).

2. Microdisc system according to claim 1, in which the lower contact electrode is made of a mixed indium and tin oxide (ITO).

3. Microdisc system according to claim 1 or 2, in which the substrate is a support used in microelectronics covered with a layer of electrically insulating material with a low refractive index.

4. Microdisc system according to claim 3, in which the substrate (2) is made from silicon covered with a layer of silicon oxide.

5. Microdisc system according to any one of claims 1 to 4, in which the microdisc (1) is made from InP.

6. Microdisc system according to any one of claims 1 to 5, in which the protective layer (3) is made from SiO₂, Si₃N₄ or SiOₓN_{y}.

7. Microdisc system according to any one of the preceding claims, in which in which the core (5) is made from material with a lower optical index than that of the material constituting the microdisc.

8. Microdisc system according to claim 7, in which the core (5) is made from SiO₂, Si₃N₄ or SiOₓN_{y}.

9. Microdisc system according to any one of the preceding claims, in which said electrical connection (9) is made from a material that is little or not absorbent at the wavelength at which the microdisc system is intended to function.

10. Microdisc system according to claim 9, in which aid electrical connection (9) is made of a mixed indium and tin oxide (ITO).

11. Microdisc system according to any one of the preceding claims, in which the lower contact (10) is a ring through which said electrical connection (9) passes.

12. Microdisc system according to any one of the preceding claims, in which the lower part of the microdisc has a greater diameter than the rest of the microdisc in order to constitute an annular part (12) on which the lower contact (11) is located.

13. Electrically pumped optical source, comprising a microdisc system according to any one of claims 1 to 12.
